(19) Europäisches Patentamt / European Patent Office / Office européen des brevets

(11) **EP 4 462 141 B1**

(12) **EUROPEAN PATENT SPECIFICATION**

(45) Date of publication and mention
of the grant of the patent:
**17.06.2026 Bulletin 2026/25**

(21) Application number: **23860663.6**

(22) Date of filing: **12.07.2023**

(51) International Patent Classification (IPC):
*G01R 31/36* (2020.01)   *G01R 31/392* (2019.01)
*G01R 31/396* (2019.01)   *G01R 31/382* (2019.01)
*G01R 31/3842* (2019.01)   *G01R 31/367* (2019.01)

(52) Cooperative Patent Classification (CPC):
**G01R 31/367; G01R 31/36; G01R 31/392;
G01R 31/396;** G01R 31/382; G01R 31/3842;
Y02E 60/10

(86) International application number:
**PCT/KR2023/009914**

(87) International publication number:
**WO 2024/048981 (07.03.2024 Gazette 2024/10)**

(54) **FAULTY BATTERY DETECTION APPARATUS AND METHOD**

VORRICHTUNG UND VERFAHREN ZUR ERKENNUNG FEHLERHAFTER BATTERIEN

APPAREIL ET PROCÉDÉ DE DÉTECTION DE BATTERIE DÉFECTUEUSE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **31.08.2022 KR 20220109748**

(43) Date of publication of application:
**13.11.2024 Bulletin 2024/46**

(73) Proprietor: **LG Energy Solution, Ltd.
Seoul 07335 (KR)**

(72) Inventor: **KIM, Eungyong
Daejeon 34122 (KR)**

(74) Representative: **Plasseraud IP
104 Rue de Richelieu
CS92104
75080 Paris Cedex 02 (FR)**

(56) References cited:
CN-A- 103 792 495      CN-A- 112 946 522
JP-B2- 4 506 606      KR-A- 20170 051 059
KR-A- 20220 037 169      US-A1- 2022 077 514
US-A1- 2022 077 514

## Description

[Technical Field]

This application claims priority to and the benefit of Korean Patent Application No.10-2022-0109748 filed in the Korean Intellectual Property Office on August 31, 2022.

The present invention relates to an apparatus and method for detecting an abnormal battery, and more particularly, to an apparatus and method for detecting an abnormal battery among a pluratlity of batteries using correlation analysis.

[Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as automobiles and an energy storage system (ESS) for smart grids.

The secondary battery is applied to a system in a form of an assembly such as a battery module in which a plurality of battery cells are connected in series and parallel or a battery pack in which battery modules are connected in series and parallel according to system requirements. In a case of medium or large-sized devices such as electric vehicles, a high-capacity battery system in which a plurality of battery packs are connected in parallel may be applied in order to satisfy a required capacity of the device.

Since battery cells included in a battery assembly operate under the same conditions, they undergo the same or very similar degradation process. Thus, abnormal battery cells can be detected by collecting state values (e.g., voltage values) for battery cells in the battery assembly and comparing the state values of the battery cells.

In the case of an abnormal battery detection method using such a deviation in the state values, misdiagnosis may occur due to a deviation in the state values caused by factors other than battery failure. For example, voltage deviation between battery cells may occur due to open circuit voltage (OCV), internal resistance (IR), and measurement errors of voltage sensors, and in this case, a corresponding battery may be detected as an abnormal battery even though no failure occurs in the corresponding battery.

As a technology that can solve these problems of the prior art, an appropriate solution to more accurately detect abnormal batteries is needed.

US2022/077514, in accordance with its abstract, describes a battery management apparatus includes a plurality of battery cells connected to one another in at least one of a series connection or a parallel connection; a detector configured to detect electrical signals of the battery cells; a monitor configured to obtain the electrical signal for each of the battery cells and values of correlation coefficient corresponding to correlation results obtained based on the electrical signals, and to generate identification signals corresponding to the electrical signals of the battery cells based on the values of correlation coefficient and a reference value; and a storage configured to store the identification signals generated by the monitor for each of the battery cells.

CN112946522, in accordance with its abstract, describes an on-line monitoring method for a short-circuit fault in a battery energy storage system caused by a low-temperature working condition.

[Detailed Description of the Invention]

[Technical Problem]

To obviate one or more problems of the related art, embodiments of the present disclosure provide an apparatus for detecting an abnormal battery with improved detection accuracy.

To obviate one or more problems of the related art, embodiments of the present disclosure also provide a method for detecting an abnormal battery by the apparatus for detecting an abnormal battery.

[Technical Solution]

In order to achieve the objective of the present disclosure, an abnormal battery detection apparatus detects at least one abnormal battery among a plurality of batteries and includes at least one processor and a memory configured to store instructions configured to be executed by the at least one processor.

Here, the instructions include an instruction which, when executed by the at least one processor, cause the at least one processor to collect state data for each of the plurality of batteries; an instruction which, when executed by the at least one processor, cause the at least one processor to calculate a correlation coefficient for each of the batteries by performing correlation analysis between battery states based on the collected state data; and an instruction which, when executed by the at least one processor, cause the at least one processor to detect the at least one abnormal battery among a plurality of batteries based on the calculated correlation coefficient.

The instructions to calculate the correlation coefficient include: an instruction which, when executed by the at least one processor, causes the at least one processor to calculate the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor.

The instructions to calculate the correlation coefficient further include: an instruction which, when executed by the at least one processor, causes the at least one processor to identify an operation mode of the batteries; and an instruction which, when executed by the at least one processor, causes the at least one processor to, upon the operation mode being charge/discharge mode, calculate the correlation coefficient using the first correlation analysis model, and upon the operation mode being idle mode, calculate the correlation coefficient using the second correlation analysis model.

Furthermore, in order to achieve the objective of the present disclosure, an abnormal battery detection apparatus detects at least one abnormal battery among a plurality of batteries, and includes at least one processor and a memory configured to store instructions configured to be executed by the at least one processor.

Here the instructions include: an instruction which, when executed by the at least one processor, causes the at least one processor to collect state data for each of the plurality of batteries; an instruction which, when executed by the at least one processor, causes the processor to calculate a correlation coefficient for each of the batteries by performing correlation analysis between battery states based on the collected state data; and an instruction which, when executed by the at least one processor, causes the at least one processor to detect the at least one abnormal battery among a plurality of batteries based on the calculated correlation coefficient.

The instructions to calculate the correlation coefficient include an instruction which, when executed by the at least one processor, causes the at least one processor to calculate the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor.

The instructions to calculate the correlation coefficient further include an instruction which, when executed by the at least one processor, causes the at least one processor to calculate a covariance of the battery state values and a covariance of noise component values; and an instruction which, when executed by the at least one processor, causes the at least one processor to calculate the correlation coefficient using the first correlation analysis model in the instance that the covariance of the battery state values exceeds the covariance of the noise component values, and to calculate the correlation coefficient using the second correlation analysis model in the instance that the covariance of the battery state values is less than or equal to the covariance of the noise component values.

The noise constant may be defined based on a measurement error value of the state measurement sensor.

The instruction to detect the at least one abnormal battery among a plurality of batteries may include an instruction which, when executed by the at least one processor, cause the at least one processor to determine a battery having the correlation coefficient below a predefined threshold as an abnormal battery.

The instruction to collect state data may include an instruction which, when executed by the at least one processor, cause the at least one processor to collect one or more of a voltage value and a current value for each of the batteries per unit time.

According to another embodiment of the present disclosure, an abnormal battery detection method is a method for detecting at least one abnormal battery among a plurality of batteries, performed by an abnormal battery detection apparatus, and includes collecting state data for each of the plurality of batteries; calculating a correlation coefficient for each of the batteries by performing correlation analysis between battery states based on the collected state data; and detecting the at least one abnormal battery among a plurality of batteries based on the calculated correlation coefficient.

The calculating the correlation coefficient for each of the batteries includes calculating the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor.

The calculating the correlation coefficient for each of the batteries further includes: identifying an operation mode of the batteries; and upon the operation mode being charge/discharge mode, calculating the correlation coefficient using the first correlation analysis model, and upon the operation mode being idle mode, calculating the correlation coefficient using the second correlation analysis model.

The noise constant may be defined based on a measurement error value of the state measurement sensor.

According to another embodiment of the present disclosure, an abnormal battery detection method is a method, performed by an abnormal battery detection apparatus, for detecting at least one abnormal battery among a plurality of batteries, the abnormal battery detection method comprising collecting state data for each of the plurality of batteries,

calculating a correlation coefficient for each of the batteries by performing correlation analysis between battery states based on the collected state data, and detecting the at least one abnormal battery among a plurality of batteries based on the calculated correlation coefficient.

The calculating the correlation coefficient for each of the batteries includes calculating the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor.

The calculating the correlation coefficient for each of the batteries includes calculating a covariance of the battery state values and a covariance of the noise component values; and calculating the correlation coefficient using the first correlation analysis model in the instance that the covariance of the battery state values exceeds the covariance of the noise component values; and calculating the correlation coefficient using the second correlation analysis model in the instance that the covariance of the battery state values is less than or equal to the covariance of the noise component values.

The detecting the at least one abnormal battery among a plurality of batteries may include determining a battery having the correlation coefficient below a predefined threshold as an abnormal battery.

The collecting state data may include collecting one or more of a voltage value and a current value for each of the batteries per unit time.

[Advantageous Effects]

According to the embodiment of the present invention as described above, an abnormal battery can be detected more accurately by detecting an abnormal battery based on a correlation coefficient derived using a correlation analysis model.

[Brief Description of the Drawings]

FIG. 1 is an operation flowchart of a general method for detecting an abnormal battery.
FIG. 2 is an example of misdiagnosis by the general method for detecting an abnormal battery.
FIG. 3 is a block diagram of an abnormal battery detection system according to embodiments of the present invention.
FIG. 4 is an operation flowchart of a method for detecting an abnormal battery according to embodiments of the present invention.
FIG. 5 is an operation flowchart of a method for deriving a correlation coefficient according to embodiments of the present invention.
FIG. 6 is an operation flowchart of a method for deriving a correlation coefficient according to another embodiment of the present invention.
FIGS. 7 to 10 show the results of detecting an abnormal battery using a correlation analysis model according to embodiments of the present invention.
FIG. 11 is a block diagram of an abnormal battery detection apparatus according to embodiments of the present invention.

10: battery
100: Battery assembly
200: Abnormal battery detection apparatus

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, and alternatives falling within the scope of the appended claims. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power and a battery module refers to an assembly in which a plurality of battery cells are electrically connected.

A battery pack or battery rack refers to a system of a minimum single structure which is assembled by electrically connecting module units, set by a battery manufacturer, and can be monitored and controlled by a battery management apparatus/system (BMS). A battery pack or battery rack may include several battery modules and a battery protection unit or any other protection device.

A battery bank refers to a group of large-scale battery rack systems configured by connecting several racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

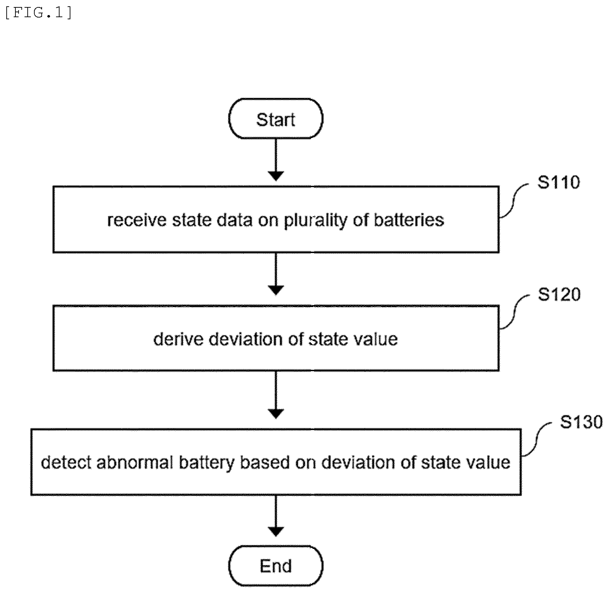

FIG. 1 is an operation flowchart of a general method for detecting an abnormal battery.

Referring to FIG. 1, according to a general method for detecting a faulty battery, an abnormal battery is detected among a plurality of batteries by using a deviation in state values of the batteries. More specifically, an abnormal battery detection device collects state data on batteries included in the battery assembly (S110). Thereafter, the abnormal battery detection device derives a deviation of the state value for each battery based on the collected state data (S120). Thereafter, the abnormal battery detection device detects a battery in which the deviation of the derived state value exceeds a predefined threshold as an abnormal battery (S130).

According to this general detecting method, misdiagnosis may occur due to deviations in state values caused by factors other than a battery fault.

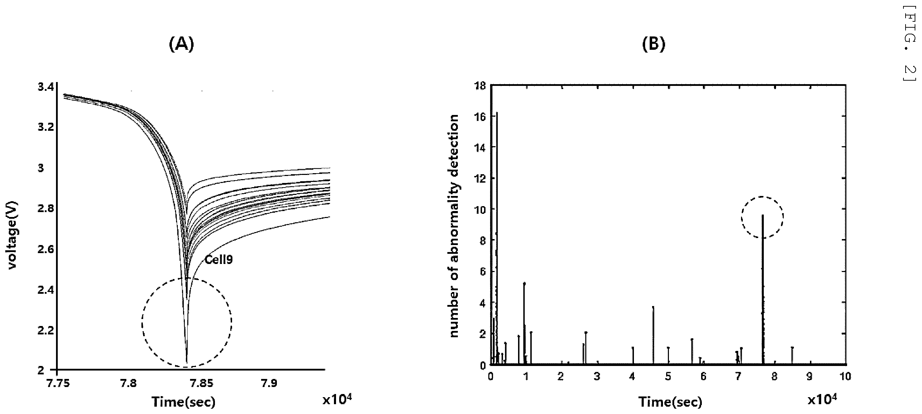

FIG. 2 is an example of misdiagnosis by the general method for detecting an abnormal battery.

(A) of FIG. 2 shows voltage values of batteries measured per unit time, and (B) of FIG. 2 shows abnormality diagnosis results based on voltage differences between battery cells.

Referring to (A) of FIG.2, due to influences of an open circuit voltage (OCV) and an internal resistance (IR), the voltage of a specific battery (Cell 9) shows a difference from voltages of other batteries, and as shown in (B) of FIG.2, a misdiagnosis, of which the specific battery is diagnosed as a faulty battery even though no fault has occurred in the specific battery, may occur due to the high voltage deviation at that point.

The present invention is presented to solve the problems caused by the general method stated above, and relates to an apparatus and method for detecting an abnormal battery, which can improve detection accuracy of an abnormal battery by preventing misdiagnosis due to factors other than failure.

Hereinafter, exemplary embodiments of the present invention will be described in detail with reference to the accompanying drawings.

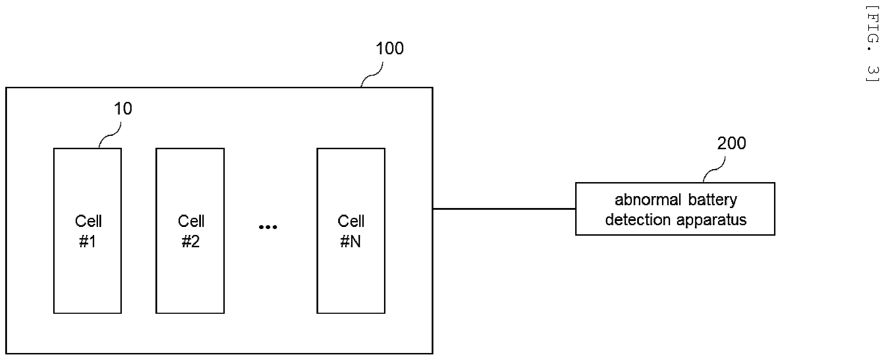

FIG. 3 is a block diagram of a system for abnormal battery detection according to embodiments of the present invention.

Referring to FIG. 3, the system for abnormal battery detection includes a battery assembly 100 including a plurality of batteries 10 and an abnormal battery detection apparatus 200.

A plurality of batteries 10 may be electrically connected to form a battery assembly 100.

The system for abnormal battery detection according to embodiments of the present invention may be included and implemented in an electric vehicle, but the scope of the present invention is not limited to this. In other words, the system for abnormal battery detection according to the present invention may be applied to a device which is equipped with a plurality of batteries and operate to detect an abnormal battery by performing an abnormal battery detection method described below.

In embodiments, the abnormal battery detection apparatus 200 may be implemented by being included in a battery management system (BMS) located inside the battery system.

The abnormal battery detection apparatus 200 collects state data for each of a plurality of batteries. Here, the state data may correspond to data about one or more state values of voltage values and current values of the battery.

The abnormal battery detection apparatus 200 may receive state data from a state measurement sensor that measures state values for each battery. For example, the abnormal battery detection apparatus 200 may receive state data from a voltage measurement sensor that senses a voltage value of each of the batteries, or a current measurement sensor that senses a value of current flowing through each of the batteries.

The abnormal battery detection apparatus 200 may collect state data at each predefined unit time. For example, the abnormal battery detection apparatus 200 may be configured to receive state data for each battery every second.

The abnormal battery detection apparatus 200 performs correlation analysis between battery states based on the collected state data and calculates a correlation coefficient for each of the batteries. Thereafter, the abnormal battery detection apparatus 200 detects an abnormal battery among the plurality of batteries based on the calculated correlation coefficients. Here, the abnormal battery detection apparatus 200 may determine a battery with a correlation coefficient less than or equal to a predefined threshold as an abnormal battery.

The abnormal battery detection apparatus according to the present invention may detect an abnormal battery based on the state values of batteries operating under the same conditions. Hereinafter, a method for detecting an abnormal battery based on voltage values of batteries connected in parallel in a battery assembly will be described as an example, but the scope of the present invention is not limited thereto.

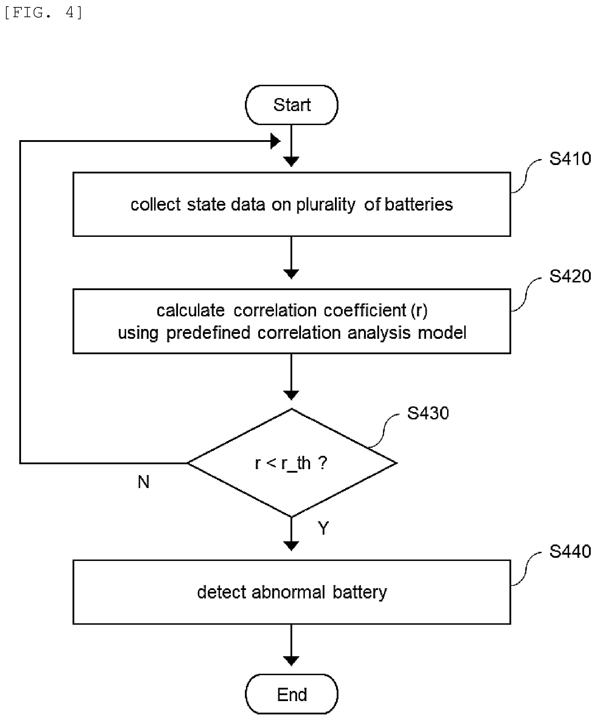

FIG. 4 is an operation flowchart of a method for detecting an abnormal battery according to embodiments of the present invention.

The abnormal battery detection apparatus 200 collects state data for each of the plurality of batteries (S410). Here, the abnormal battery detection apparatus 200 may collect state data on one or more of a voltage value and a current value for each battery per unit time.

The abnormal battery detection apparatus 200 performs correlation analysis between battery states based on the collected state data and calculates a correlation coefficient (r) for each of the batteries (S420).

The abnormal battery detection apparatus 200 may calculate a correlation coefficient for each battery using a predefined correlation analysis model. Here, the correlation analysis model may be defined so that when state data for a plurality of batteries is input, a correlation coefficient for each of the batteries is output.

The correlation analysis model according to a first correlation analysis model of the present invention is defined based on a standard deviation and a covariance of the battery state values. For example, the first correlation analysis model may be defined based on Equation 1 below.

[Equation 1]

$$r_{X,Y} = \frac{COV_{X,Y}}{\sigma_X \sigma_Y} = \frac{\sum_{i=1}^{n}(x_i - \mu_x)(y_i - \mu_y)}{\sqrt{\sum_{i=1}^{n}(x_i - \mu_x)^2}\sqrt{\sum_{i=1}^{n}(y_i - \mu_y)^2}}$$

Here, $r_{X,Y}$ refers to a correlation coefficient between battery X and battery Y, $COV_{X,Y}$ refers to a covariance of the state values of battery X and battery Y, $\sigma_X$ means a standard deviation of the state value of battery X, and $\sigma_Y$ means a standard deviation of the state value of battery Y. In addition, x refers to the state value of battery X, $\mu_x$ is an average value of the state values of battery X for a predetermined period of time, y refers to the state value of battery Y, and $\mu_y$ means an average value of state values of battery Y for a predetermined period of time.

When deriving a correlation coefficient for a specific battery (e.g. Cell_1) based on Equation 1, the state data for the battery (Cell_1) is input as x, and the state data for other batteries are input as y to the correlation analysis model. Here, y may correspond to the average value or median value of the state values of other batteries. In embodiments, in order to accurately calculate the correlation coefficient, the abnormal battery detection apparatus 200 may correct the median value of the state values of other batteries according to a predefined process, and input the corrected median value as y into the correlation analysis model.

When a correlation coefficient is calculated using the first correlation analysis model according to embodiments of the present invention, and an abnormal battery is detected based on the calculated correlation coefficient, misdiagnosis due to the influence of open circuit voltage (OCV) or internal resistance (IR) can be prevented.

More specifically, in Equation 1 above, when the change in voltage values ($\alpha X + \beta$) due to the influence of open circuit voltage (OCV) or internal resistance (IR) is reflected, the average value of the voltage values also changes accordingly and thus, the correlation coefficient may be calculated as the same value as the correlation coefficient according to equation 1, as shown in equation 2 below.

[Equation 2]

$$r_{\alpha X + \beta, Y} = r_{X,Y}$$

The abnormal battery detection apparatus 200 may calculate a correlation coefficient using the first correlation analysis model defined based on Equation 1, and detect an abnormal battery using the calculated correlation coefficient, and thus, misdiagnosis due to the influence of open circuit voltage (OCV) or internal resistance (IR) can be prevented.
In step S420, the abnormal battery detection apparatus 200 may calculate a correlation coefficient for each of the batteries using a correlation analysis model according to a second correlation analysis model. Here, the second correlation analysis model is defined based on a standard deviation, a covariance, and a noise constant of the battery state values. For example, the correlation analysis model can be defined based on Equation 3 below.

[Equation 3]

$$r_{X,Y} = \frac{\sum_{i=1}^{n}(x_i - \mu_x)(y_i - \mu_y) + N}{\sqrt{\sum_{i=1}^{n}(x_i - \mu_x)^2}\sqrt{\sum_{i=1}^{n}(y_i - \mu_y)^2} + N}$$

Here, N refers to a noise constant and can be defined as Equation 4 below.

[Equation 4]

N = **a** * RMS(Noise)

Here, RMS (Noise) is a RMS (Root Mean Square) value of a measurement error value of a state measurement sensor, and a is a weighting coefficient.
Referring to Equation 3, the second correlation analysis model is a model in which a noise constant (N) is reflected in the first correlation analysis model to remove the influence of sensing noise of the state measurement sensor.
Generally, state values measured by a state measurement sensor include noise components. Equation 1 can be expressed as follows if these noise components are reflected in Equation 1.

[Equation 5]

$$r_{X+N, Y+M} = \frac{COV_{X+N, Y+M}}{\sigma_{X+N}\sigma_{Y+M}}$$

$$= \frac{\sum_{i=1}^{n}(x_i - \mu_x)(y_i - \mu_y) + \sum_{i=1}^{n}(N_i - \mu_N)(M_i - \mu_M)}{\sqrt{\sum_{i=1}^{n}(x_i - \mu_x)^2 + \sum_{i=1}^{n}(N_i - \mu_N)^2}\sqrt{\sum_{i=1}^{n}(y_i - \mu_y)^2 + \sum_{i=1}^{n}(M_i - \mu_M)^2}}$$

$$= \frac{COV_{X,Y} + COV_{N,M}}{\sigma_{X+N}\sigma_{Y+M}}$$

Here, N means a noise component of x, and M means a noise component of y.
Depending on the relationship between the noise component and the original state value (the value from which the noise component is removed from the measured value), the following two cases can be assumed.

(case1)

$$COV_{X,Y} > COV_{N,M}$$

(case2)

$$COV_{X,Y} \leq COV_{N,M}$$

Case 1 is a case where the amount of change in the original state values is greater than that of the noise components, and may correspond, for example, to a charging/discharging period of the battery. In Case 1, since the amount of change in the original state values is larger than that of the noise components, the influence of the sensing noise of the state measurement sensor is small, and thus, the detection accuracy is not significantly reduced even if the correlation coefficient is calculated using the first correlation analysis model.

Case 2 is a case where the amount of change in the original state values is less than or equal to that of the noise components, and may correspond, for example, to an idle period of the battery. In Case 2, since the change in noise components is larger than the change in the original state values, misdiagnosis may occur due to the influence of sensing noise when calculating the correlation coefficient using the first correlation analysis model.

In case 2, when $COV_{X,Y} = COV_{N,M}$, the noise components and the original state values have the same level of change, so equation 5 can be simplified as follows.

[Equation 6]

$$r_{X+N,Y+M} = \frac{COV_{X,Y}+COV_{N,M}}{\sigma_{X+N}\sigma_{Y+M}} \cong \frac{2*COV_{N,M}}{\sigma_{2*N}\sigma_{2*M}} =$$

$$\frac{2*\sum_{i=1}^{n}\left(N_i-\mu_N\right)\left(M_i-\mu_M\right)}{\sqrt{2*\sum_{i=1}^{n}\left(N_i-\mu_N\right)^2}\sqrt{2*\sum_{i=1}^{n}\left(M_i-\mu_M\right)^2}} =$$

$$\frac{\sum_{i=1}^{n}\left(N_i-\mu_N\right)\left(M_i-\mu_M\right)}{\sqrt{\sum_{i=1}^{n}\left(N_i-\mu_N\right)^2}\sqrt{\sum_{i=1}^{n}\left(M_i-\mu_M\right)^2}} = r_{N,M}$$

Here, if the noise component is white noise, the average value ($\mu N$, $\mu M$) of the noise components is 0, and if the state values of the batteries were measured by the same sensor, N = M, so equation 6 can be represented as follows.

[Equation 7]

$$r_{N,M} = \frac{\sum_{i=1}^{n}(N_i - \mu_N)(M_i - \mu_M)}{\sqrt{\sum_{i=1}^{n}(N_i - \mu_N)^2}\sqrt{\sum_{i=1}^{n}(M_i - \mu_M)^2}} = \frac{\sum_{i=1}^{n}(N_i)(M_i)}{\sqrt{\sum_{i=1}^{n}(N_i)^2}\sqrt{\sum_{i=1}^{n}(M_i)^2}} = 1$$

In other words, in case 2, since the same result can be obtained even if the correlation coefficient ($r_{X+N,Y+M}$) is calculated by adding an appropriate noise constant N to the numerator and the denominator of equation 1, respectively, the second correlation analysis model defined according to equation 3 can be used.

The noise constant N may be defined as RMS (Noise) multiplied by the weighting coefficient a, according to Equation 4. For example, the noise constant N may be defined as the RMS value of 5 mV, which is the measurement error value of the voltage sensor, multiplied by a weighting factor of 0.8.

The weighting coefficient a is a value for adjusting detection accuracy and may be defined as a specific value between 0.2 and 1.1, and preferably, a specific value between 0.8 and 1.0.

The abnormal battery detection apparatus 200 calculates the correlation coefficient using the second correlation analysis model defined based on equation 3 for case 2 (e.g., idle mode), but, in example not falling into the claimed subject-matter, the correlation coefficient may be calculated using a second correlation analysis model even for case 1 (e.g., charge/discharge mode), in order to achieve higher detection accuracy.

The abnormal battery detection apparatus 200 may compare the correlation coefficient (r) calculated for each battery in step S420 with a predefined threshold (r_th) (S430). The correlation coefficient (r) according to embodiments of the present invention may indicate a degree to which the state of a specific battery is correlated with states of other batteries, and may be calculated as a specific value between -1 and 1. A battery with a correlation coefficient (r) close to 1 may be considered to have high correlation with other batteries, and a battery with a correlation coefficient (r) close to 0 may be considered as having low correlation with other batteries.

The abnormal battery detection apparatus 200 may determine a battery having a correlation coefficient less than or equal to the threshold value (r_th) as an abnormal battery (S440). For example, when the threshold (r_th) is defined as 0.5, the abnormal battery detection apparatus 200 may determine a battery with a correlation coefficient of 0.5 or less among a plurality of batteries as an abnormal battery. Meanwhile, the threshold value (r_th) may be determined as an appropriate value as needed and may be defined as a specific value between 0.4 and 0.8.

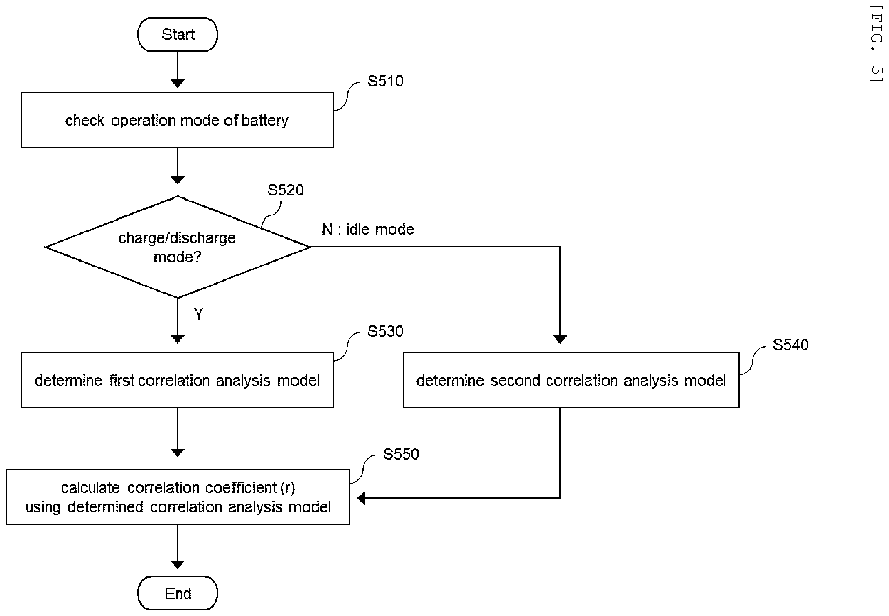

FIG. 5 is an operation flowchart of a method for deriving a correlation coefficient according to a first embodiments of the present invention.

The abnormal battery detection apparatus 200 checks the operation mode of the batteries (S510). Here, the operation mode includes charge/discharge mode and idle mode.

The abnormal battery detection apparatus 200 may determine an operation mode based on output current values or input current values for the batteries. For example, the operation mode may be determined as the idle mode if the output or input current value of the batteries is 0, and the operation mode may be determined as the charge/discharge mode if the output or input current value is not 0.

The abnormal battery detection apparatus 200 may also determine the operation mode based on a battery operation state signal received from an external device. For example, the abnormal battery detection apparatus 200 may receive a battery operation state signal from a battery charge/discharge control device and determine whether the battery is in a charge/discharge state or an idle state.

When the operation mode of the battery is the charge/discharge mode (Y in S520), the abnormal battery detection apparatus 200 determines a first correlation analysis model defined based on equation 1 as a model for calculating the correlation coefficient (S530).

When the operation mode of the battery is the idle mode (N in S520), the abnormal battery detection apparatus 200 determines a second correlation analysis model defined based on equation 3 as a model for calculating the correlation coefficient (S540).

The abnormal battery detection apparatus 200 derives a correlation coefficient (r) for each of the batteries using the correlation analysis model determined according to the operation mode of the battery (S550).

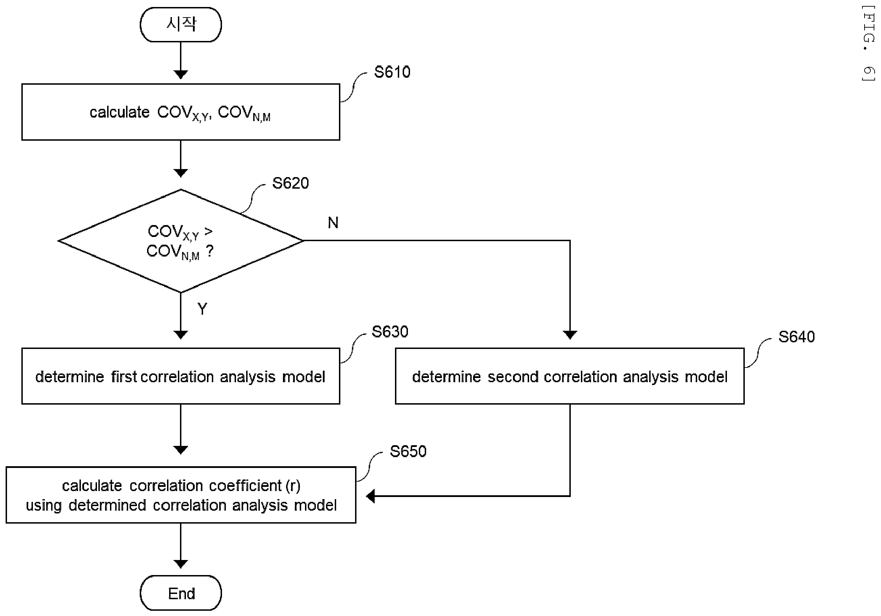

FIG. 6 is an operation flowchart of a method for deriving a correlation coefficient according to a second embodiment of the present invention.

The abnormal battery detection apparatus 200 calculates $COV_{X,Y}$ and $COV_{N,M}$ based on the state data of the batteries (S610).

Here, $COV_{X,Y}$ and $COV_{N,M}$ may be calculated based on the equations below.

[Equation 8]

$$COV_{X,Y} = \sum_{i=1}^{n}(x_i - \mu_x)(y_i - \mu_y)$$

[Equation 9]

$$COV_{N,M} = \sum_{i=1}^{n}(N_i - \mu_N)(M_i - \mu_M)$$

The abnormal battery detection apparatus 200 compares $COV_{X,Y}$ and $COV_{N,M}$ (S620).

When $COV_{X,Y}$ exceeds $COV_{N,M}$ (Y in S620), the abnormal battery detection apparatus 200 determines the first correlation analysis model defined based on equation 1 as a model for calculating the correlation coefficient (S630).

When $COV_{X,Y}$ is less than or equal to $COV_{N,M}$ (N in S620), the abnormal battery detection apparatus 200 determines the second correlation analysis model defined based on equation 3 as a model for calculating the correlation coefficient (S640).

The abnormal battery detection apparatus 200 derives a correlation coefficient (r) for each of the batteries using the correlation analysis model determined according to the operation mode of the battery (S650).

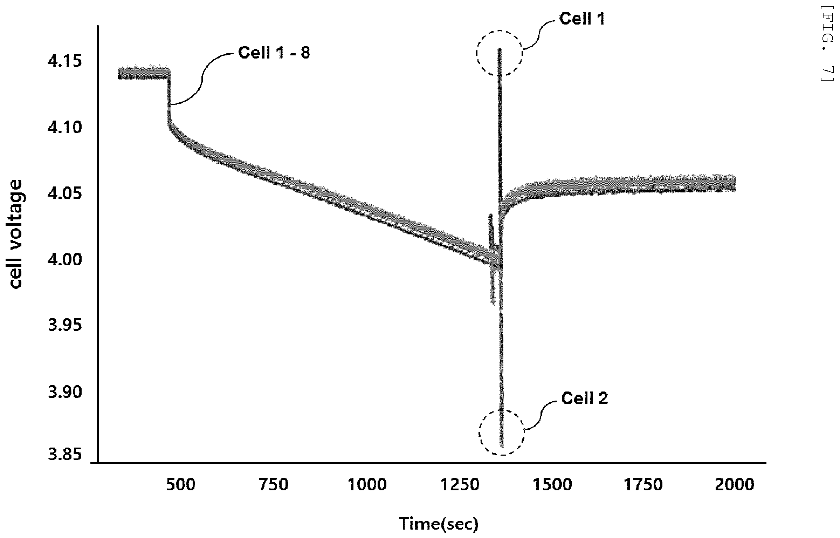

FIGS. 7 to 10 show the results of detecting an abnormal battery using a correlation analysis model according to embodiments of the present invention.

FIG.7 shows voltage measurement values for each of eight batteries (Cells 1 to 8) connected in parallel. Referring to FIG. 7, it seems that an abnormal voltage phenomenon occurs in Cell 1 and Cell 2 approximately at 1375 sec.

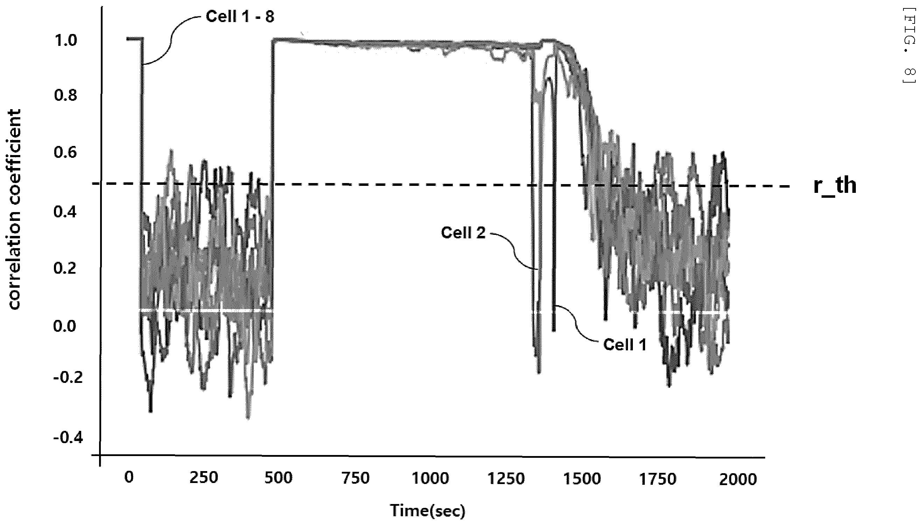

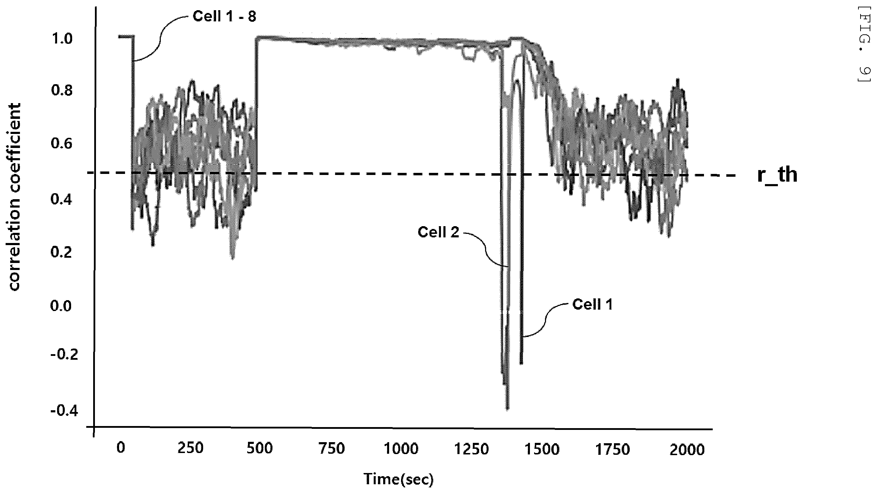

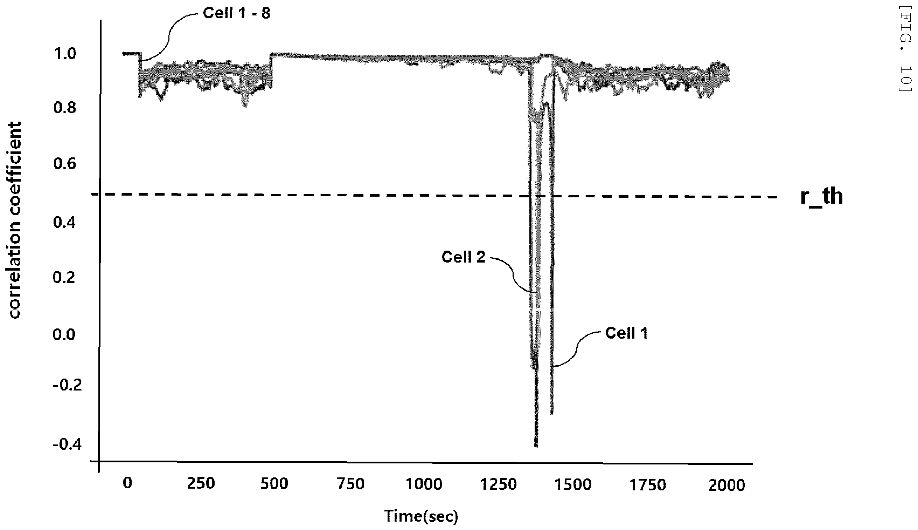

FIGS. 8 to 10 show correlation coefficients for each battery cell calculated by applying a correlation analysis model according to embodiments of the present invention. FIG.8 is a graph of the results of applying the first correlation analysis model, FIG.9 is a graph of the results of applying the second correlation analysis model where the weighting coefficient a is defined as 0.1 and the RMS (Noise) is defined as an RMS value of 0.5 mV, and FIG.10 is a graph of the results of applying the second correlation analysis model where the weighting coefficient a is 1.0 and the RMS (Noise) is defined as an RMS value of 0.5 mV. The threshold (r_th) for detecting an abnormal battery is set to 0.5.

Referring to FIG. 8, when using the first correlation analysis model, a battery with a correlation coefficient of equal to or less than the threshold value (0.5) is detected in a section other than the time point where the abnormal voltage phenomenon occurred, and a false detection was made that cells 3 to 8 are classified as abnormal batteries.

Referring to FIG. 9, when using the second correlation analysis model in which the weighting coefficient a is defined as 0.1, a battery with a correlation coefficient of equal to or less than the threshold value (0.5) is detected in a section other than the time point where the abnormal voltage phenomenon occurred, and a false detection was made that cells 3 to 8 are classified as abnormal batteries, as in the case of FIG.8.

Referring to FIG. 10, when using the second correlation analysis model in which the weighting coefficient a is defined as 1.0, cell 1 and cell 2 are detected as batteries with a correlation coefficient equal to or less than the threshold value (0.5).

Referring to FIGS. 8 to 10, it can be understood that when the second correlation analysis model with a weighting coefficient within optimal range (0.2 or more and 1.1 or less) is applied, abnormal battery detection can be performed with high accuracy.

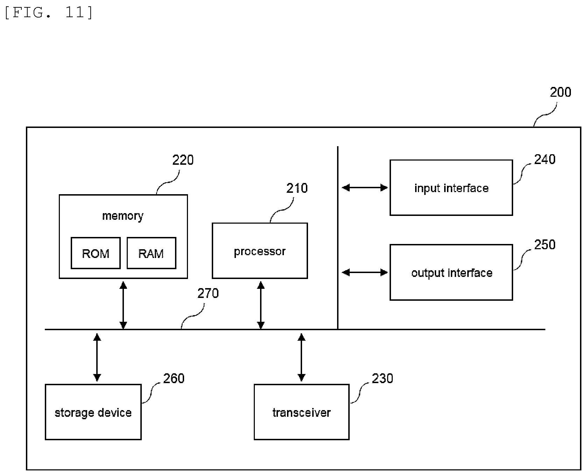

FIG. 11 is a block diagram of an abnormal battery detection apparatus according to embodiments of the present invention.

The abnormal battery detection apparatus 200 according to embodiments of the present invention includes at least one processor 210 and a memory 220 that stores at least one command executed through the processor, and a transceiver 230 that is connected to a network to perform communication.

Here, the at least one instruction includes an instruction to collect state data for each of the plurality of batteries; an instruction to calculate a correlation coefficient for each of the batteries by performing correlation analysis between battery states based on the collected state data; and an instruction to detect the at least one abnormal battery among a plurality of batteries based on the calculated correlation coefficient.

The instruction to calculate the correlation coefficient includes an instruction to calculate the correlation coefficient for each of the batteries using a correlation analysis model which is defined based on a standard deviation and a covariance of battery state values.

Here, the instruction to calculate the correlation coefficient includes an instruction to calculate a correlation coefficient in which influence of sensing noise of a state measurement sensor is removed using a correlation analysis model on which a predefined noise constant is reflected.

The noise constant may be defined based on a measurement error value of the state measurement sensor.

The instruction to calculate the correlation coefficient includes an instruction to calculate the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor.

In a first embodiment, the instruction to calculate the correlation coefficient includes an instruction to identify the operation mode of the batteries; and an instruction to, upon the operation mode being charge/discharge mode, calculate the correlation coefficient using the first correlation analysis model, and upon the operation mode being idle mode, calculate the correlation coefficient using the second correlation analysis model.

In a second embodiment, the instruction to calculate the correlation coefficient includes an instruction to calculate a covariance of the battery state values and a covariance of the noise component values; and an instruction to calculate the correlation coefficient using the first correlation analysis model in the instance that the covariance of the battery state values exceeds the covariance of the noise component values, and to calculate the correlation coefficient using the second correlation analysis model in the instance that the covariance of the battery state values is less than or equal to the covariance of the noise component values.

The instruction to detect the at least one abnormal battery among a plurality of batteries may include an instruction to determine a battery having the correlation coefficient below a predefined threshold as an abnormal battery.

The instruction to collect state data may include an instruction to collect one or more of a voltage value and a current value for each of the batteries per unit time.

The abnormal battery detection apparatus 200 may further include an input interface 240, an output interface 250, a storage device 260, etc. Respective components included in the abnormal battery detection apparatus 200 are connected by a bus 270 and can communicate with one another.

Here, the processor 210 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range described in the appending claims.

**Claims**

1.  An abnormal battery detection apparatus (200) for detecting at least one abnormal battery among a plurality of batteries (10), the abnormal battery detection apparatus comprising:

    at least one processor (210); and
    a memory (220) configured to store instructions configured to be executed by the at least one processor, wherein the instructions include:

    an instruction which, when executed by the at least one processor, causes the at least one processor to collect state data for each of the plurality of batteries;
    an instruction which, when executed by the at least one processor, causes the at least one processor to calculate a correlation coefficient for each of the batteries by performing correlation analysis between battery states based on the collected state data; and
    an instruction which, when executed by the at least one processor, causes the at least one processor to detect the at least one abnormal battery among a plurality of batteries based on the calculated correlation coefficient wherein the instructions to calculate the correlation coefficient include:

    an instruction which, when executed by the at least one processor, causes the at least one processor to calculate the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor (230),
    **characterized in that**
    the instructions to calculate the correlation coefficient further include:

    an instruction which, when executed by the at least one processor, causes the at least one processor to identify an operation mode of the batteries; and
    an instruction which, when executed by the at least one processor, causes the at least one processor to, upon the operation mode being charge/discharge mode, calculate the correlation coefficient using the first correlation analysis model, and upon the operation mode being idle mode, calculate the correlation coefficient using the second correlation analysis model.

2. An abnormal battery detection apparatus (200) for detecting at least one abnormal battery among a plurality of batteries (10), the abnormal battery detection apparatus comprising:

at least one processor (210); and
a memory (220) configured to store instructions configured to be executed by the at least one processor, wherein the instructions include:

an instruction which, when executed by the at least one processor, causes the at least one processor to collect state data for each of the plurality of batteries;
an instruction which, when executed by the at least one processor, causes the at least one processor to calculate a correlation coefficient for each of the batteries by performing correlation analysis between battery states based on the collected state data; and
an instruction which, when executed by the at least one processor, causes the at least one processor to detect the at least one abnormal battery among a plurality of batteries based on the calculated correlation coefficient wherein the instructions to calculate the correlation coefficient include:

an instruction which, when executed by the at least one processor, causes the at least one processor to calculate the correlation coefficient using either one of a first correlation analysis model which is defined based on standard deviation and covariance of battery state values and a second correlation analysis model in which a noise constant is reflected to the first correlation analysis model so as to remove the influence by sensing noise of a state measurement sensor (230),
**characterized in that**
the instructions to calculate the correlation coefficient further include:

an instruction which, when executed by the at least one processor, causes the at least one processor to calculate a covariance of the battery state values and a covariance of noise component values; and
an instruction which, when executed by the at least one processor, causes the at least one processor to calculate the correlation coefficient using the first correlation analysis model in the instance that the covariance of the battery state values exceeds the covariance of the noise component values, and to calculate the correlation coefficient using the second correlation analysis model in the instance that the covariance of the battery state values is less than or equal to the covariance of the noise component values.

3. The abnormal battery detection apparatus of claim 1 or 2, wherein the noise constant is defined based on a measurement error value of the state measurement sensor.

4. The abnormal battery detection apparatus of claim 1 or 2, wherein the instruction to detect the at least one abnormal battery among a plurality of batteries includes:
an instruction which, when executed by the at least one processor, cause the at least one processor to determine a battery having the correlation coefficient below a predefined threshold as an abnormal battery.

5. The abnormal battery detection apparatus of claim 1 or 2, wherein the instruction to collect the state data includes:
an instruction which, when executed by the at least one processor, cause the at least one processor to collect one or more of a voltage value and a current value for each of the batteries per unit time.

6. An abnormal battery detection method, performed by an abnormal battery detection apparatus (200) for detecting at least one abnormal battery among a plurality of batteries (10), the abnormal battery detection method comprising:

collecting (S410) state data for each of the plurality of batteries;
calculating (420) a correlation coefficient for each of the batteries by performing correlation analysis between battery states based on the collected state data; and
detecting (S440) the at least one abnormal battery among a plurality of batteries based on the calculated correlation coefficient,
wherein the calculating the correlation coefficient for each of the batteries includes:

calculating the correlation coefficient using either one of a first correlation analysis model (S530, S630) which is defined based on standard deviation and covariance of battery state values and a second correlation analysis model (S540, S640) in which a noise constant is reflected to the first correlation analysis model so as to remove the influence by sensing noise of a state measurement sensor,

**characterized in that**

the calculating the correlation coefficient for each of the batteries further includes:

identifying (S510) an operation mode of the batteries; and

upon the operation mode being charge/discharge mode (S520), calculating (S550) the correlation coefficient using the first correlation analysis model, and upon the operation mode being idle mode, calculating (S540) the correlation coefficient using the second correlation analysis model.

7. An abnormal battery detection method, performed by an abnormal battery detection apparatus (200) for detecting at least one abnormal battery among a plurality of batteries (10), the abnormal battery detection method comprising:

collecting (S410) state data for each of the plurality of batteries;

calculating (420) a correlation coefficient for each of the batteries by performing correlation analysis between battery states based on the collected state data; and

detecting (S440) the at least one abnormal battery among a plurality of batteries based on the calculated correlation coefficient,

wherein the calculating the correlation coefficient for each of the batteries includes:

calculating the correlation coefficient using either one of a first correlation analysis model (S530, S630) which is defined based on standard deviation and covariance of battery state values and a second correlation analysis model (S540, S640) in which a noise constant is reflected to the first correlation analysis model so as to remove the influence by sensing noise of a state measurement sensor,

**characterized in that**

the calculating the correlation coefficient for each of the batteries includes:

calculating (S610) a covariance of the battery state values and a covariance of noise component values; and

calculating (S650) the correlation coefficient using the first correlation analysis model in the instance that the covariance of the battery state values exceeds the covariance of the noise component values; and calculating (S640) the correlation coefficient using the second correlation analysis model in the instance that the covariance of the battery state values is less than or equal to the covariance of the noise component values.

8. The abnormal battery detection method of claim 7, wherein the detecting the at least one abnormal battery among a plurality of batteries includes:

determining a battery having the correlation coefficient below a predefined threshold as an abnormal battery.

**Patentansprüche**

1. Abnormale-Batterie-Detektionsvorrichtung (200) zum Detektieren wenigstens einer abnormalen Batterie unter einer Mehrzahl von Batterien (10), wobei die Abnormale-Batterie-Detektionsvorrichtung umfasst:

wenigstens einen Prozessor (210); und

einen Speicher (220), welcher dazu eingerichtet ist, Anweisungen zu speichern, welche dazu eingerichtet sind, durch den wenigstens einen Prozessor ausgeführt zu werden,

wobei die Anweisungen umfassen:

eine Anweisung, welche, wenn sie durch den wenigstens einen Prozessor ausgeführt wird, bewirkt, dass der wenigstens eine Prozessor Zustandsdaten für jede der Mehrzahl von Batterien sammelt;

eine Anweisung, welche, wenn sie durch den wenigstens einen Prozessor ausgeführt wird, bewirkt, dass der wenigstens eine Prozessor einen Korrelationskoeffizienten für jede der Batterien durch Durchführen einer Korrelationsanalyse zwischen Batteriezuständen basierend auf den gesammelten Zustandsdaten berechnet; und

eine Anweisung, welche, wenn sie durch den wenigstens einen Prozessor ausgeführt wird, bewirkt, dass der wenigstens eine Prozessor die wenigstens eine abnormale Batterie unter einer Mehrzahl von Batterien basierend auf dem berechneten Korrelationskoeffizienten detektiert,

wobei die Anweisungen zum Berechnen des Korrelationskoeffizienten umfassen:

eine Anweisung, welche, wenn sie durch den wenigstens einen Prozessor ausgeführt wird, bewirkt, dass der wenigstens eine Prozessor den Korrelationskoeffizienten unter Verwendung von einem aus einem ersten Korrelationsanalysemodell, welches basierend auf Standardabweichung und Kovarianz von Batteriezustandswerten definiert ist, und einem zweiten Korrelationsanalysemodell, in welchem eine Rauschkonstante auf das erste Korrelationsanalysemodell reflektiert ist, um den Einfluss durch Erfassungsrauschen eines Zustandsmesssensors (230) zu beseitigen,

**dadurch gekennzeichnet, dass**

die Anweisungen, den Korrelationskoeffizienten zu berechnen, ferner umfassen:

eine Anweisung, welche, wenn sie durch den wenigstens einen Prozessor ausgeführt wird, bewirkt, dass der wenigstens eine Prozessor einen Betriebsmodus der Batterien identifiziert; und

eine Anweisung, welche, wenn sie durch den wenigstens einen Prozessor ausgeführt wird, bewirkt, dass der wenigstens eine Prozessor, wenn der Betriebsmodus ein Lade-/Entlademodus ist, den Korrelationskoeffizienten unter Verwendung des ersten Korrelationsanalysemodells berechnet, und wenn der Betriebsmodus ein Leerlaufmodus ist, den Korrelationskoeffizienten unter Verwendung des zweiten Korrelationsanalysemodells berechnet.

2. Abnormale-Batterie-Detektionsvorrichtung (200) zum Detektieren wenigstens einer abnormalen Batterie unter einer Mehrzahl von Batterien (10), wobei die Abnormale-Batterie-Detektionsvorrichtung umfasst:

wenigstens einen Prozessor (210); und

einen Speicher (220), welcher dazu eingerichtet ist, Anweisungen zu speichern, welche dazu eingerichtet sind, durch den wenigstens einen Prozessor ausgeführt zu werden,

wobei die Anweisungen umfassen:

eine Anweisung, welche, wenn sie durch den wenigstens einen Prozessor ausgeführt wird, bewirkt, dass der wenigstens eine Prozessor Zustandsdaten für jede der Mehrzahl von Batterien sammelt;

eine Anweisung, welche, wenn sie durch den wenigstens einen Prozessor ausgeführt wird, bewirkt, dass der wenigstens eine Prozessor einen Korrelationskoeffizienten für jede der Batterien durch Durchführen einer Korrelationsanalyse zwischen Batteriezuständen basierend auf den gesammelten Zustandsdaten berechnet; und

eine Anweisung, welche, wenn sie durch den wenigstens einen Prozessor ausgeführt wird, bewirkt, dass der wenigstens eine Prozessor die wenigstens eine abnormale Batterie unter einer Mehrzahl von Batterien basierend auf dem berechneten Korrelationskoeffizienten detektiert,

wobei die Anweisungen zum Berechnen des Korrelationskoeffizienten umfassen:

eine Anweisung, welche, wenn sie durch den wenigstens einen Prozessor ausgeführt wird, bewirkt, dass der wenigstens eine Prozessor den Korrelationskoeffizienten unter Verwendung von einem aus einem ersten Korrelationsanalysemodell, welches basierend auf Standardabweichung und Kovarianz von Batteriezustandswerten definiert ist, und einem zweiten Korrelationsanalysemodell, in welchem eine Rauschkonstante auf das erste Korrelationsanalysemodell reflektiert ist, um den Einfluss durch Erfassungsrauschen eines Zustandsmesssensors (230) zu beseitigen,

**dadurch gekennzeichnet, dass**

die Anweisungen, den Korrelationskoeffizienten zu berechnen, ferner umfassen:

eine Anweisung, welche, wenn sie durch den wenigstens einen Prozessor ausgeführt wird, bewirkt, dass der wenigstens eine Prozessor eine Kovarianz der Batteriezustandswerte und eine Kovarianz der Rauschkomponentenwerte berechnet; und

eine Anweisung, welche, wenn sie durch den wenigstens einen Prozessor ausgeführt wird, bewirkt, dass der wenigstens eine Prozessor in dem Fall, dass die Kovarianz der Batteriezustandswerte die Kovarianz der Rauschkomponentenwerte übersteigt, den Korrelationskoeffizienten unter Verwendung des ersten Korrelationsanalysemodells berechnet, und in dem Fall, dass die Kovarianz der Batteriezustandswerte weniger oder gleich der Kovarianz der Rauschkomponentenwerte ist, den Korrelationskoeffizienten unter Verwendung des zweiten Korrelationsanalysemodells berechnet.

**3.** Abnormale-Batterie-Detektionsvorrichtung nach Anspruch 1 oder 2, wobei die Rauschkonstante basierend auf einem Messfehlerwert des Zustandsmesssensors definiert ist.

**4.** Abnormale-Batterie-Detektionsvorrichtung nach Anspruch 1 oder 2, wobei die Anweisung, die wenigstens eine abnormale Batterie unter einer Mehrzahl von Batterien zu detektieren, umfasst:
eine Anweisung, welche, wenn sie durch den wenigstens einen Prozessor ausgeführt wird, bewirkt, dass der wenigstens eine Prozessor eine Batterie mit dem Korrelationskoeffizienten unter einem vordefinierten Schwellenwert als eine abnormale Batterie bestimmt.

**5.** Abnormale-Batterie-Detektionsvorrichtung nach Anspruch 1 oder 2, wobei die Anweisung, Zustandsdaten zu sammeln, umfasst:
eine Anweisung, welche, wenn sie durch den wenigstens einen Prozessor ausgeführt wird, bewirkt, dass der wenigstens eine Prozessor pro Einheitszeit einen oder mehrere aus einem Spannungswert und einem Stromwert für jede der Batterien sammelt.

**6.** Abnormale-Batterie-Detektionsverfahren, welches durch eine Abnormale-Batterie-Detektionsvorrichtung (200) zum Detektieren wenigstens einer abnormalen Batterie unter einer Mehrzahl von Batterien (10) durchgeführt wird, wobei das Abnormale-Batterie-Detektionsverfahren umfasst:

Sammeln (S410) von Zustandsdaten für jede der Mehrzahl von Batterien;
Berechnen (420) eines Korrelationskoeffizienten für jede der Batterien durch Durchführen einer Korrelationsanalyse zwischen Batteriezuständen basierend auf den gesammelten Zustandsdaten; und
Detektieren (S440) der wenigstens einen abnormalen Batterie unter einer Mehrzahl von Batterien basierend auf dem berechneten Korrelationskoeffizienten,
wobei das Berechnen des Korrelationskoeffizienten für jede der Batterien umfasst:

Berechnen des Korrelationskoeffizienten unter Verwendung von einem aus einem ersten Korrelationsanalysemodell (S530, S630), welches basierend auf Standardabweichung und Kovarianz von Batteriezustandswerten definiert ist, und einem zweiten Korrelationsanalysemodell (S540, S640), in welchem eine Rauschkonstante auf das erste Korrelationsanalysemodell reflektiert ist, um den Einfluss durch Erfassungsrauschen eines Zustandsmesssensors (230) zu beseitigen,
**dadurch gekennzeichnet, dass** das Berechnen des Korrelationskoeffizienten für jede der Batterien ferner umfasst:

Identifizieren (S510) eines Betriebsmodus der Batterien; und
wenn der Betriebsmodus ein Lade-/Entlademodus ist (S520), Berechnen (S550) des Korrelationskoeffizienten unter Verwendung des ersten Korrelationsanalysemodells, und wenn der Betriebsmodus ein Leerlaufmodus ist, Berechnen (S540) des Korrelationskoeffizienten unter Verwendung des zweiten Korrelationsanalysemodells.

**7.** Abnormale-Batterie-Detektionsverfahren, welches durch eine Abnormale-Batterie-Detektionsvorrichtung (200) zum Detektieren wenigstens einer abnormalen Batterie unter einer Mehrzahl von Batterien (10) durchgeführt wird, wobei das Abnormale-Batterie-Detektionsverfahren umfasst:

Sammeln (S410) von Zustandsdaten für jede der Mehrzahl von Batterien;
Berechnen (420) eines Korrelationskoeffizienten für jede der Batterien durch Durchführen einer Korrelationsanalyse zwischen Batteriezuständen basierend auf den gesammelten Zustandsdaten; und
Detektieren (S440) der wenigstens einen abnormalen Batterie unter einer Mehrzahl von Batterien basierend auf dem berechneten Korrelationskoeffizienten,
wobei das Berechnen des Korrelationskoeffizienten für jede der Batterien umfasst:

Berechnen des Korrelationskoeffizienten unter Verwendung von einem aus einem ersten Korrelationsanalysemodell (S530, S630), welches basierend auf Standardabweichung und Kovarianz von Batteriezustandswerten definiert ist, und einem zweiten Korrelationsanalysemodell (S540, S640), in welchem eine Rauschkonstante auf das erste Korrelationsanalysemodell reflektiert ist, um den Einfluss durch Erfassungsrauschen eines Zustandsmesssensors zu beseitigen,

**dadurch gekennzeichnet, dass** das Berechnen des Korrelationskoeffizienten für jede der Batterien umfasst:

Berechnen (S610) einer Kovarianz der Batteriezustandswerte und einer Kovarianz der Rauschkomponentenwerte; und

Berechnen (S650) des Korrelationskoeffizienten unter Verwendung des ersten Korrelationsanalysemodells in dem Fall, dass die Kovarianz der Batteriezustandswerte die Kovarianz der Rauschkomponentenwerte übersteigt; und Berechnen (S640) des Korrelationskoeffizienten unter Verwendung des zweiten Korrelationsanalysemodells in dem Fall, dass die Kovarianz der Batteriezustandswerte weniger als oder gleich der Kovarianz der Rauschkomponentenwerte ist.

8. Abnormale-Batterie-Detektionsverfahren nach Anspruch 7, wobei das Detektieren der wenigstens einen abnormalen Batterie unter einer Mehrzahl von Batterien umfasst:
Bestimmen einer Batterie mit dem Korrelationskoeffizienten unter einem vordefinierten Schwellenwert als eine abnormale Batterie.


## Revendications

1. Appareil (200) de détection de batterie anormale pour détecter au moins une batterie anormale parmi une pluralité de batteries (10), l'appareil de détection de batterie anormale comprenant :

au moins un processeur (210) ; et
une mémoire (220) configurée pour stocker des instructions configurées pour être exécutées par l'au moins un processeur,
dans lequel les instructions incluent :

une instruction qui, lorsqu'elle est exécutée par l'au moins un processeur, amène l'au moins un processeur à collecter des données d'état pour chacune de la pluralité de batteries ;
une instruction qui, lorsqu'elle est exécutée par l'au moins un processeur, amène l'au moins un processeur à calculer un coefficient de corrélation pour chacune des batteries en réalisant une analyse de corrélation entre les états de batterie sur la base des données d'état collectées ; et
une instruction qui, lorsqu'elle est exécutée par l'au moins un processeur, amène l'au moins un processeur à détecter l'au moins une batterie anormale parmi une pluralité de batteries sur la base du coefficient de corrélation calculé
dans lequel les instructions pour calculer le coefficient de corrélation incluent :

une instruction qui, lorsqu'elle est exécutée par l'au moins un processeur, amène l'au moins un processeur à calculer le coefficient de corrélation en utilisant l'un ou l'autre d'un premier modèle d'analyse de corrélation qui est défini sur la base d'un écart-type et d'une covariance de valeurs d'état de batterie et d'un second modèle d'analyse de corrélation dans lequel une constante de bruit figure dans le premier modèle d'analyse de corrélation de manière à éliminer l'influence du bruit de détection d'un capteur de mesure d'état (230),
**caractérisé en ce que**
les instructions pour calculer le coefficient de corrélation incluent en outre :

une instruction qui, lorsqu'elle est exécutée par l'au moins un processeur, amène l'au moins un processeur à identifier un mode de fonctionnement des batteries ; et
une instruction qui, lorsqu'elle est exécutée par l'au moins un processeur, amène l'au moins un processeur à, lorsque le mode de fonctionnement est un mode de charge/décharge, calculer le coefficient de corrélation en utilisant le premier modèle d'analyse de corrélation, et lorsque le mode de fonctionnement est un mode de repos,
calculer le coefficient de corrélation en utilisant le second modèle d'analyse de corrélation.

2. Appareil (200) de détection de batterie anormale pour détecter au moins une batterie anormale parmi une pluralité de batteries (10), l'appareil de détection de batterie anormale comprenant :

au moins un processeur (210) ; et

une mémoire (220) configurée pour stocker des instructions configurées pour être exécutées par l'au moins un processeur,

dans lequel les instructions incluent :

une instruction qui, lorsqu'elle est exécutée par l'au moins un processeur, amène l'au moins un processeur à collecter des données d'état pour chacune de la pluralité de batteries ;

une instruction qui, lorsqu'elle est exécutée par l'au moins un processeur, amène l'au moins un processeur à calculer un coefficient de corrélation pour chacune des batteries en réalisant une analyse de corrélation entre les états de batterie sur la base des données d'état collectées ; et

une instruction qui, lorsqu'elle est exécutée par l'au moins un processeur, amène l'au moins un processeur à détecter l'au moins une batterie anormale parmi une pluralité de batteries sur la base du coefficient de corrélation calculé

dans lequel les instructions pour calculer le coefficient de corrélation incluent :

une instruction qui, lorsqu'elle est exécutée par l'au moins un processeur, amène l'au moins un processeur à calculer le coefficient de corrélation en utilisant l'un ou l'autre d'un premier modèle d'analyse de corrélation qui est défini sur la base d'un écart-type et d'une covariance de valeurs d'état de batterie et d'un second modèle d'analyse de corrélation dans lequel une constante de bruit figure dans le premier modèle d'analyse de corrélation de manière à éliminer l'influence du bruit de détection d'un capteur de mesure d'état (230),

**caractérisé en ce que**

les instructions pour calculer le coefficient de corrélation incluent en outre :

une instruction qui, lorsqu'elle est exécutée par l'au moins un processeur, amène l'au moins un processeur à calculer une covariance des valeurs d'état de batterie et une covariance des valeurs de composante de bruit ; et

une instruction qui, lorsqu'elle est exécutée par l'au moins un processeur, amène l'au moins un processeur à calculer le coefficient de corrélation en utilisant le premier modèle d'analyse de corrélation dans le cas où la covariance des valeurs d'état de batterie dépasse la covariance des valeurs de composante de bruit, et à calculer le coefficient de corrélation en utilisant le second modèle d'analyse de corrélation dans le cas où la covariance des valeurs d'état de batterie est inférieure ou égale à la covariance des valeurs de composante de bruit.

3. Appareil de détection de batterie anormale selon la revendication 1 ou 2, dans lequel la constante de bruit est définie sur la base d'une valeur d'erreur de mesure du capteur de mesure d'état.

4. Appareil de détection de batterie anormale selon la revendication 1 ou 2, dans lequel l'instruction pour détecter l'au moins une batterie anormale parmi une pluralité de batteries inclut :

une instruction qui, lorsqu'elle est exécutée par l'au moins un processeur, amène l'au moins un processeur à déterminer qu'une batterie dont le coefficient de corrélation est au-dessous d'un seuil prédéfini est une batterie anormale.

5. Appareil de détection de batterie anormale selon la revendication 1 ou 2, dans lequel l'instruction pour collecter les données d'état inclut :

une instruction qui, lorsqu'elle est exécutée par l'au moins un processeur, amène l'au moins un processeur à collecter une ou plusieurs parmi une valeur de tension et une valeur de courant pour chacune des batteries par unité de temps.

6. Procédé de détection de batterie anormale, réalisé par un appareil (200) de détection de batterie anormale pour détecter au moins une batterie anormale parmi une pluralité de batteries (10), le procédé de détection de batterie anormale comprenant :

la collecte (S410) de données d'état pour chacune de la pluralité de batteries ;

le calcul (420) d'un coefficient de corrélation pour chacune des batteries en réalisant une analyse de corrélation entre les états de batterie sur la base des données d'état collectées ; et

la détection (S440) de l'au moins une batterie anormale parmi une pluralité de batteries sur la base du coefficient de corrélation calculé,

dans lequel le calcul du coefficient de corrélation pour chacune des batteries inclut :

le calcul du coefficient de corrélation en utilisant l'un ou l'autre d'un premier modèle d'analyse de corrélation (S530, S630) qui est défini sur la base d'un écart-type et d'une covariance de valeurs d'état de batterie et d'un second modèle d'analyse de corrélation (S540, S640) dans lequel une constante de bruit figure dans le premier modèle d'analyse de corrélation de manière à éliminer l'influence du bruit de détection d'un capteur de mesure d'état,

**caractérisé en ce que**

le calcul du coefficient de corrélation pour chacune des batteries inclut en outre :

l'identification (S510) d'un mode de fonctionnement des batteries ; et

lorsque le mode de fonctionnement est un mode de charge/décharge (S520), le calcul (S550) du coefficient de corrélation en utilisant le premier modèle d'analyse de corrélation, et lorsque le mode de fonctionnement est un mode de repos, le calcul (S540) du coefficient de corrélation en utilisant le second modèle d'analyse de corrélation.

7. Procédé de détection de batterie anormale, réalisé par un appareil (200) de détection de batterie anormale pour détecter au moins une batterie anormale parmi une pluralité de batteries (10), le procédé de détection de batterie anormale comprenant :

la collecte (S410) de données d'état pour chacune de la pluralité de batteries ;

le calcul (420) d'un coefficient de corrélation pour chacune des batteries en réalisant une analyse de corrélation entre les états de batterie sur la base des données d'état collectées ; et

la détection (S440) de l'au moins une batterie anormale parmi une pluralité de batteries sur la base du coefficient de corrélation calculé,

dans lequel le calcul du coefficient de corrélation pour chacune des batteries inclut :

le calcul du coefficient de corrélation en utilisant l'un ou l'autre d'un premier modèle d'analyse de corrélation (S530, S630) qui est défini sur la base d'un écart-type et d'une covariance de valeurs d'état de batterie et d'un second modèle d'analyse de corrélation (S540, S640) dans lequel une constante de bruit figure dans le premier modèle d'analyse de corrélation de manière à éliminer l'influence du bruit de détection d'un capteur de mesure d'état,

**caractérisé en ce que**

le calcul du coefficient de corrélation pour chacune des batteries inclut :

le calcul (S610) d'une covariance des valeurs d'état de batterie et d'une covariance des valeurs de composante de bruit ; et

le calcul (S650) du coefficient de corrélation en utilisant le premier modèle d'analyse de corrélation dans le cas où la covariance des valeurs d'état de batterie dépasse la covariance des valeurs de composante de bruit ; et le calcul (S640) du coefficient de corrélation en utilisant le second modèle d'analyse de corrélation dans le cas où la covariance des valeurs d'état de batterie est inférieure ou égale à la covariance des valeurs de composante de bruit.

8. Procédé de détection de batterie anormale selon la revendication 7, dans lequel la détection de l'au moins une batterie anormale parmi une pluralité de batteries inclut : la détermination qu'une batterie dont le coefficient de corrélation est au-dessous d'un seuil prédéfini est une batterie anormale.

[FIG.1]

[FIG. 2]

[FIG. 3]

[FIG. 4]

Start

S410
collect state data on plurality of batteries

S420
calculate correlation coefficient (r)
using predefined correlation analysis model

S430
r < r_th ?

N

Y

S440
detect abnormal battery

End

[FIG. 5]

EP 4 462 141 B1

[FIG. 6]

[FIG. 7]

[FIG. 8]

[FIG. 9]

[FIG. 10]

[FIG. 11]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220109748
- US 2022077514 A
- CN 112946522